# EUROPEAN PATENT APPLICATION

(11) **EP 1 120 903 A1**
(43) Date of publication of application: **01.08.2001**
(21) Application number: 00300612.9
(22) Date of filing: 27.01.2000
(51) Int. Cl.: H03F 1/32, H03G 3/20

(54) **Transmission feedback system**

(71) Applicant: TTP Communications Limited, Royston, Hertfordshire, SG8 6EE (GB)
(72) Inventor: Hildersley, Julian, c/o TTP Communications Ltd., Royston, Hertfordshire SG8 6EE (GB)
(74) Representative: Haley, Stephen

(57) **Abstract**

A modulation feedback system for use with a transmitter power amplifier. The system comprises means for sampling, in use, the output of a power amplifier. Vector modulator means receives the output from the sampling means and applies a Cartesian representation of the desired modulation thereto. Means receives the output of the vector modulator means and means for employing the output to modulate, both in phase and amplitude terms, the input to the power amplifier in use.

## Description

This invention relates to feedback control systems for employment in the generation of amplitude and phase modulated radio frequency carrier waves of high power.

There are currently many types of feedback systems employed to control the output of high power amplifier associated with radio frequency carrier wave transmission.

Some known systems use modulation feedback to control a power amplifier but suffer from a number of disadvantages and are therefore not widely used. In systems which use Cartesian feedback, the wide band noise floor that is produced by any vector modulator which is employed results in a requirement for complex filtering to ensure duplex operation. In systems which use polar feedback, the amplitude and phase components suffer from differential delays if the loops associated with each are not matched, which can result in inaccurate modulation and can create spectral distortion.

The present invention seeks to overcome some of the above problems.

According to the present invention there is provided a modulation feedback system for use with a transmitter power amplifier, the system comprising:
means for sampling, in use, the output of a power amplifier;
vector modulator means for receiving the output from the sampling means and applying a Cartesian representation of the desired modulation thereto; and
means for receiving the output of the vector modulator means and means for employing the output to modulate, both in phase and amplitude terms, the input to the power amplifier in use.

The system may further comprise a frequency convertor for mixing the output of a reference frequency oscillator with the signal from the sampling means.

The system may further comprise a variable gain amplifier for scaling the output of the sampling means.

The phase modulation may be performed by provision of a limiter for limiting a signal from the vector modulator; a frequency mixer for mixing a reference with the output of the limiter; and a phase loop filter for filtering the output of the frequency mixer and applying an input to a frequency controlled oscillator.

The amplitude modulation may be performed by provision of an envelope detector; a comparator for comparing the output of the envelope detect with a reference amplitude; and a amplitude loop filter.

One example of the present invention will now be described with reference to the accompanying drawings, in which:-
Figure 1 is a schematic diagram of a first example of the present invention;
Figure 2 is a schematic diagram of a second example of the present invention; and
Figure 3 is a schematic diagram of a third example of the present invention.

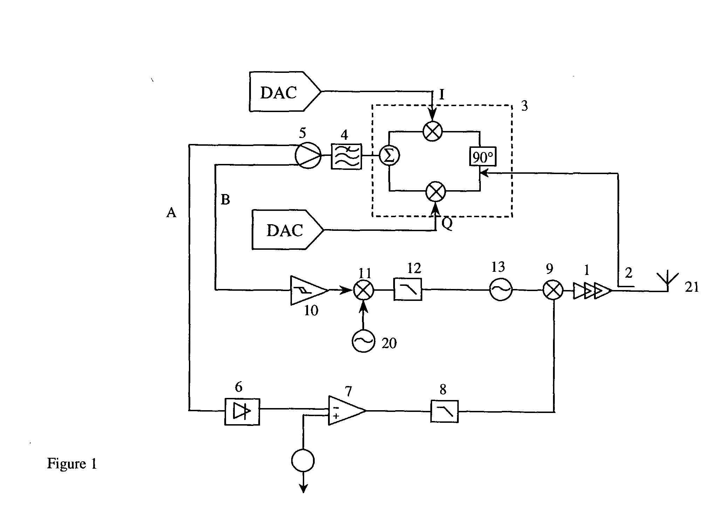

Referring to figure 1, a power amplifier 1 provides an amplified signal to an antenna 21 at a level sufficient to ensure that the transmitted RF power from the transmitter is sufficient for the application for which the antenna 21 is being employed. Sampling means 2 samples the output of the power amplifier 1 and provides it to a vector modulator 3, which is used to provide an error signal based upon the sampled output and a reference quadrature representation of the modulation that it is desired for the output of the power amplifier 1 to have.

A filter 4 is provided to remove harmonics from the output from the vector modulator means 3. A splitter 5 is provided to split the output from the filter 4 and provide it to two feedback paths A and B.

Path A comprises an envelope detector 6 which extracts amplitude information from the signal from the filter 4. It further comprises an amplitude reference generator and a comparator 7 for comparing the output of the envelope detector 6 with the generated referenced amplitude. The output from the comparator 7 is filtered by a further filter 8 and provided to an amplitude modulator 9.

Path B comprises a limiter 10 which extracts phase information from the output of the filter 4 and a phase comparator 11 which compares the output of the limiter 10 with a reference frequency. A filter 12 is provided to filter the output of the phase comparator 11 and the output of the filter 12 is then forwarded to a voltage controlled oscillator 13. The output of the voltage controlled oscillator 13 is then forwarded to the amplitude modulator 9, the output of which is provided to the amplifier 1 in order to close the feedback loops.

The operation of the invention will now be described. If we consider signal flow starting at the output of the power amplifier 1. At this point, for ease of understanding it should be assumed that there is a RF carrier with near-ideal complex modulation applied to it. A sample of this RF signal is collected by the sampling means 2 and used as a feedback signal. The feedback signal is applied to a local oscillator input in the vector modulator 3. Here ideal complex modulation, represented as quadrature based components is applied to the feedback signal so as to cancel the modulation on the feedback signal. Thus, at the output of the vector modulator 3, there is provided a RF carrier wave with complex error modulation applied. The complex error modulation results from the difference between the ideal modulation represented by the quadrature based band signals applied to the vector modulator 3 and the actual complex modulation on the sampled signal.

After filtering to remove harmonics the signal output from the vector modulator 3 is split. Signal path A has a baseband representation of the amplitude of the signal generated by the envelope detector 6 in a manner which is independent of any phase modulation. After comparison with a reference amplitude by the comparator 7 the resulting signal represents an error in amplitude between ideal modulation and the modulation present at the output of the power amplifier 1. After further filtering this signal is applied to the amplitude modulator 9.

The other portion of the split signal from the vector modulator output is sent via path B and applied to a limiter 10 which produces a phase-modulated carrier wave independent of any amplitude modulation. The output of the limiter 10 is applied to a phase comparator 11, where it is compared with a stable phase/frequency reference 20. The resulting base band signal represents the error in phase between an ideal modulation and the modulation at the output of the power amplifier 1.

The phase error signal thus generated is filtered by a filter 12 and used to control the frequency of a variable frequency oscillator 13.

The output of the variable frequency oscillator 13 is a phase-modulated carrier wave of constant amplitude. This output is then applied to the amplitude modulator 9 and amplitude modulated from the signal from path A such that the resulting signal carrier's complex modulation closely related to the ideal modulation represented by the quadrature baseband components applied to the vector modulator 3, but predistorted to compensate for the nonlinearity of the power amplifier 1. The complex modulator signal is applied to the input of the non-linear power amplifier 1, resulting in an undistorted, high power, complex modulated signal at its output. Thus, both the amplitude and phase modulation loops are closed.

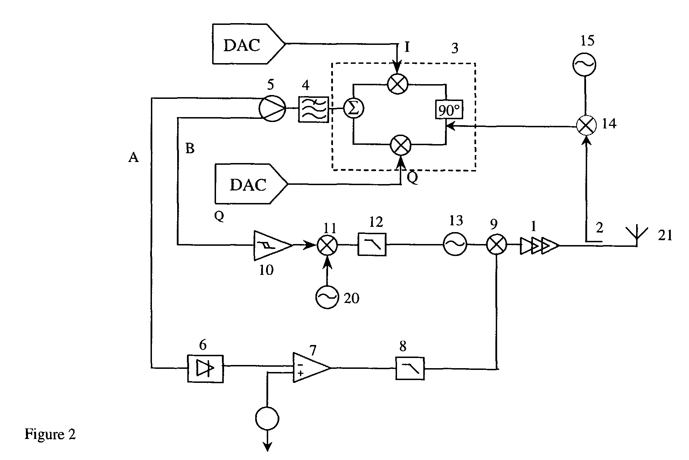

Fig. 2 shows a further example of the present invention in which there is further provided a frequency convertor 14 which mixes the output of the sampling means 2 with the output of a reference local oscillator 15. The spectrum output from the frequency convertor 14 will have a centre frequency equal to that of the stable phase frequency reference 20. Thus, the loop operates as per the example shown in Fig. 1, except that the output frequency and the reference frequency differ by the local oscillator frequency. Thus, if the output from the local oscillator 15 is variable then the output frequency will also vary, but the vector modulator 3, together with all of the other signal processing opponents, may operate at a fixed frequency with narrow bandwidth by appropriate control of variations in the local oscillator frequency.

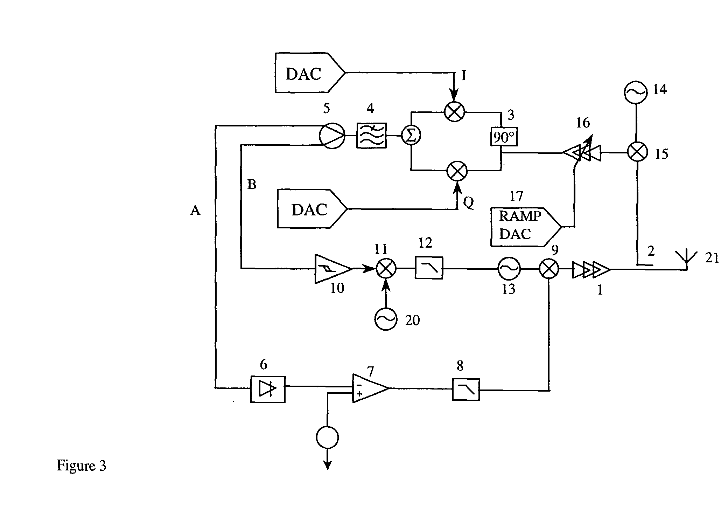

Fig. 3 shows a further example of the present invention in which a variable gain amplifier 16 is provided in the sampling path in combination with the additional features of Fig. 2. In this case, the amplitude output signal from the power amplifier 1 is sampled by the sampling means 2, but is scaled by the variable gain amplifier 16 before it is applied to the vector modulator 3. Thus, by appropriate control of the gain of the variable gain amplifier 16 it is possible to reduce the dynamic range of the remaining processing components. This provides particular benefits, in that it allows the invention to support shaped pulses in TDMA systems without increasing the resolution required in the quadrature base band representation.

## Claims

1. A modulation feedback system for use with a transmitter power amplifier, the system comprising:
means for sampling, in use, the output of a power amplifier;
vector modulator means for receiving the output from the sampling means and applying a Cartesian representation of the desired modulation thereto; and
means for receiving the output of the vector modulator means and means for employing the output to modulate, both in phase and amplitude terms, the input to the power amplifier in use.

2. A system according to claim 1, further comprising a frequency convertor for mixing the output of a reference frequency oscillator with the signal from the sampling means.

3. A system according to claim 1 or claim 2, further comprising a variable gain amplifier or variable attenuator for scaling the output of the sampling means.

4. A system according to any preceding claim further comprising a phase modulator comprising a limiter for limiting a signal from the vector modulator;
a frequency mixer for mixing a reference with the output of the limiter; and a phase loop filter for filtering the output of the frequency mixer and applying an input to a frequency controlled oscillator.

5. A system according to any preceding claim further comprising an amplitude modulator comprising:
an envelope detector; a comparator for comparing the output of the envelope detect with a reference amplitude; and a amplitude loop filter.
